Europäisches Patentamt

European Patent Office

Office européen des brevets

(19)

(11) **EP 1 630 814 A1**

(12) **DEMANDE DE BREVET EUROPEEN**

(43) Date de publication:
**01.03.2006 Bulletin 2006/09**

(51) Int Cl.:
*G11C 7/12* (2006.01)    *G11C 7/10* (2006.01)

(21) Numéro de dépôt: **05358010.6**

(22) Date de dépôt: **23.08.2005**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **26.08.2004 FR 0409108**

(71) Demandeur: **STMicroelectronics SA**
**92210 Montrouge (FR)**

(72) Inventeurs:
• **La Rosa, Francesco**
  **13790 Rousset (FR)**
• **Giovinazzi, Thierry**
  **13100 Aix en Provence (FR)**

(74) Mandataire: **Marchand, André**
**OMNIPAT,**
**24 Place des Martyrs de la Résistance**
**13100 Aix-en-Provence (FR)**

(54) **Procédé de lecture de cellules mémoire programmables et effacables électriquement, à précharge anticipée de lignes de bit**

(57) L'invention concerne un procédé de lecture de cellules mémoire (CELi,j,k) au moyen d'amplificateurs de lecture (SAi), les cellules mémoire étant reliées à des lignes de bit (BLi,j), la lecture de chaque cellule mémoire comprenant une phase de précharge de la ligne de bit à laquelle la cellule mémoire est reliée et une phase de lecture proprement dite de la cellule mémoire. Selon l'invention, chaque amplificateur de lecture (SAi) est utilisé pour précharger au moins deux lignes de bit, puis pour lire une cellule mémoire et une seule dans l'une des lignes de bit préchargées. Application notamment aux mémoires série, pour la précharge anticipée de lignes de bit ayant la même adresse partielle, pendant la réception d'une adresse de lecture.

Fig. 2

EP 1 630 814 A1

**Description**

La présente invention concerne les mémoires électroniques et notamment les mémoires programmables et effaçables électriquement, notamment les mémoires EEPROM et les mémoires FLASH (FLASH-EEPROM).

La présente invention concerne la lecture de mots binaires dans de telles mémoires et plus particulièrement dans les mémoires à entrée/sortie série.

Dans le brevet EP 712 133, la demanderesse a déjà exposé le problème rencontré avec les mémoires série, tenant dans la quasi-impossibilité de prévoir des amplificateurs de lecture adaptés aux cadences imposées par les bus série de type synchrone. En effet le temps Tr conféré pour la lecture d'un mot binaire dans une mémoire à accès série s'étend entre l'instant où le dernier bit d'adresse est reçu par la mémoire et l'instant où le premier bit du mot désigné par cette adresse est émis par la mémoire. Comme la lecture d'un bit d'adresse s'effectue généralement au milieu d'une période d'horloge, et l'émission d'un bit de donnée au commencement d'une période d'horloge, le temps Tr est au minimum égal à une demi-période d'horloge. En pratique, le temps Tr est de l'ordre de 1,5 périodes d'horloge avec un bus de type I2C (une pause d'un cycle d'horloge étant accordée entre la réception du dernier bit d'adresse et l'émission du premier bit du mot lu), de 1 période d'horloge avec un bus de type Microwire, et de l'ordre de 0,5 période d'horloge avec un bus de type SPI, qui constitue le pire cas en ce qui concerne l'exigence de rapidité de lecture des mémoires.

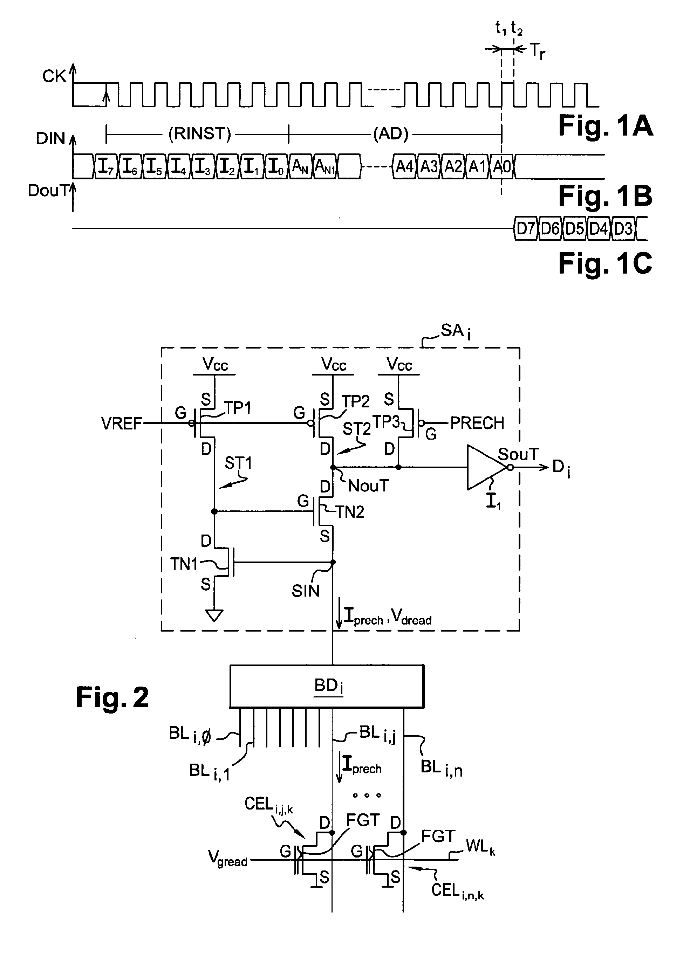

Pour fixer les idées, une séquence de lecture d'un mot binaire dans une mémoire série est illustrée sur les figures 1A, 1B, 1C. La figure 1A représente des bits de données DIN appliqués à la mémoire, la figure 1B représente un signal d'horloge CK appliqué à la mémoire, et la figure 1C représente les bits de données DOUT fournis par la mémoire. La mémoire reçoit tout d'abord des bits de données I7, I6...I0 formant une instruction de lecture (RINST) puis des bits $A_N$, $A_{N-1}$,....A2, A1, A0 formant l'adresse du mot à lire. Le dernier bit d'adresse A0 est reçu à un instant t1 correspondant au front montant d'une impulsion du signal d'horloge CK. A un instant t2 correspondant au front descendant de la même impulsion d'horloge (bus SPI), le premier bit D7 du mot lu désigné par l'adresse reçue doit être fourni en tant que donnée sortante DOUT. Le temps Tr est donc égal à t2-t1 et est égal ici à un demi cycle d'horloge. Pendant le temps Tr, l'adresse reçue doit être appliquée à un décodeur d'adresse de la mémoire, le mot désigné par l'adresse reçue doit être lu, le mot lu doit être chargé dans un registre de sortie à entrée parallèle et sortie série, et un signal de décalage doit être appliqué au registre de sortie pour que le premier bit D7 du mot lu soit émis.

De plus, la fréquence d'horloge des bus série n'a cessé d'augmenter ces dernières années. Elle était de l'ordre de 1 MHz il y a une dizaine d'années, soit une période d'horloge de l'ordre de la microseconde qui conférait un temps de lecture Tr de l'ordre de 0,5 microseconde dans le pire cas (bus SPI). Elle est fréquemment de l'ordre de 20 MHz à l'heure actuelle, soit une période d'horloge de 50 nanosecondes et un temps de lecture Tr court de l'ordre de 25 nanosecondes.

Pour pallier cet inconvénient, le brevet EP 712 133 décrit un procédé de lecture consistant à déclencher une opération de lecture avant que tous les bits d'adresse ne soient reçus, ce qui implique de lire simultanément M mots binaires ayant la même adresse partielle (adresse en cours de réception dont les bits d'adresse de plus faible poids ne sont pas encore connus). Les bits d'adresse étant reçus au rythme du signal d'horloge, le gain de temps est égal à la période du signal d'horloge multipliée par le nombre N de bits d'adresse anticipés.

L'inconvénient de ce procédé de lecture anticipée est de nécessiter la prévision d'un nombre de circuits de lecture ("sense amplifier") plus important que dans une mémoire conventionnelle. Ainsi, seize circuits de lecture au lieu de huit doivent être prévus pour une lecture par anticipation de deux octets, trente-deux circuits de lecture doivent être prévus au lieu de huit pour une lecture anticipée de quatre octets, etc.

Dans le brevet EP 1 172 820, ce problème est identifié et un procédé permettant de réduire le nombre d'amplificateurs de lecture nécessaire à une lecture anticipée est proposé. Très schématiquement, ce procédé consiste à lire de façon anticipée une partie seulement des mots binaires ayant la même adresse partielle. En contrepartie, ce procédé de lecture partielle par anticipation nécessite un entrelacement assez complexe des lignes de bit du plan mémoire, de manière qu'un même amplificateur de lecture puisse lire deux bits de rangs différents du même mot binaire et que deux amplificateurs de lecture différents puissent lire simultanément deux bits de même rang de deux mots binaires ayant des adresses partielles identiques.

La présente invention vise une solution alternative au procédé décrit par le brevet EP 1 172 820. Plus particulièrement, la présente invention vise un procédé de lecture applicable à une mémoire série, qui permette d'effectuer une lecture rapide de cellules mémoire dès réception du dernier bit d'adresse.

A cet effet, la présente invention se fonde sur le fait que le processus de lecture d'une cellule mémoire comprend classiquement deux phases distinctes : une phase de précharge d'une ligne de bit à laquelle la cellule mémoire à lire est reliée, et une phase de lecture proprement dite de la cellule mémoire. Une telle phase de précharge de la ligne de bit permet de porter la ligne de bit à une tension de lecture déterminée, généralement de l'ordre de 1V, formant la tension drain-source du transistor à grille flottante de la cellule mémoire à lire. Une telle phase de précharge est indispensable en raison des capacités parasites présentes sur la ligne de bit, notamment les capacités de drain des cellules mémoire reliées à la ligne de bit, les capacités des contacts métalliques présents sur la ligne de bit, la capacité parasite de la ligne de bit elle-même, etc.

Or, d'après des constatations sur lesquelles se fonde la présente invention, la durée de la phase de précharge n'est pas négligeable par rapport à la durée de la phase de lecture proprement dite d'une cellule mémoire. Typiquement, la précharge d'une ligne de bit représente 50% à 80% du temps de lecture global d'une cellule mémoire.

Ainsi, une idée de la présente invention est d'utiliser un même amplificateur de lecture pour précharger plusieurs lignes de bit. Ensuite, lorsque la phase de lecture proprement dite est déclenchée, l'amplificateur de lecture n'est utilisé pour ne lire qu'une seule cellule mémoire se trouvant sur l'une des lignes de bit préchargées. Un tel procédé de lecture s'applique avantageusement à une mémoire série et comprend alors le fait de précharger des lignes de bit de même adresse partielle avec le même amplificateur de lecture, puis, lorsque l'adresse complète est connue, lire les cellules mémoire désignées par l'adresse complète. Les lignes de bit correspondantes étant déjà préchargées, au moins en partie, lorsque l'adresse complète est connue, la lecture proprement dite des cellules mémoire peut être faite dans le bref délai imposé par le protocole de communication série, soit 0,5 ou 1,5 cycles d'horloge selon les exemples cités plus haut.

Plus particulièrement, la présente invention prévoit un procédé de lecture de cellules mémoire au moyen d'amplificateurs de lecture, les cellules mémoire étant reliées à des lignes de bit, la lecture de chaque cellule mémoire comprenant une phase de précharge de la ligne de bit à laquelle la cellule mémoire est reliée et une phase de lecture proprement dite de la cellule mémoire, dans lequel chaque amplificateur de lecture est utilisé pour précharger au moins deux lignes de bit, puis pour lire une cellule mémoire et une seule sur l'une des lignes de bit préchargées.

Selon un mode de réalisation, chaque amplificateur de lecture est relié à un groupe de lignes de bit par l'intermédiaire d'un décodeur de colonne, et le décodeur est utilisé pour relier chaque amplificateur de lecture à au moins deux lignes de bit pendant la phase de précharge, puis, pendant la phase de lecture, pour relier chaque amplificateur de lecture à une ligne de bit et une seule.

Selon un mode de réalisation, le décodeur de colonne comprend des blocs décodeurs pilotés par des signaux de prédécodage fournis par un étage prédécodeur recevant une adresse de colonne, chaque bloc décodeur reliant un amplificateur de lecture à un groupe de lignes de bit, et le procédé comprend une étape consistant à, pendant la précharge de lignes de bit, forcer le prédécodeur à fournir des signaux de prédécodage de valeur déterminée, de manière que chaque bloc décodeur relie un amplificateur de lecture à au moins deux lignes de bit, puis, pendant la phase de lecture, libérer le prédécodeur de manière que chaque bloc décodeur relie un amplificateur de lecture à une ligne de bit et une seule.

Selon un mode de réalisation, le procédé est appliqué à une mémoire série recevant bit à bit une adresse de lecture et comprend les étapes suivantes : sur réception d'une adresse partielle de lecture à laquelle il manque au moins un bit de plus faible poids pour former une adresse complète, précharger des lignes de bit ayant la même adresse partielle en utilisant un seul et même amplificateur de lecture pour précharger au moins deux lignes de bit, et sur réception de l'adresse complète, arrêter de précharger les lignes de bit qui ne sont pas désignées par l'adresse complète, et lire les cellules mémoire désignées par l'adresse complète.

Selon un mode de réalisation, les lignes de bit désignées par l'adresse complète continuent à être préchargées après réception de l'adresse complète, avant d'engager la lecture proprement dite des cellules mémoire désignées par l'adresse complète.

Selon un mode de réalisation, le procédé comprend les étapes suivantes : sur réception d'une première adresse partielle de lecture à laquelle il manque au moins deux bits de plus faible poids pour former une adresse complète, précharger les lignes de bit ayant la même adresse partielle, et sur réception du bit d'adresse suivant formant avec la première adresse partielle une seconde adresse partielle, arrêter de précharger des lignes de bit qui ne sont pas désignées par la seconde adresse partielle, afin de réduire la charge capacitive vue par les amplificateurs de lecture et accélérer la précharge des lignes de bit restant sélectionnées.

La présente invention concerne également une mémoire comprenant des cellules mémoire reliées à des lignes de bit, des amplificateurs de lecture et un décodeur de colonne reliant chaque amplificateur de lecture à un groupe de lignes de bit, dans laquelle la lecture de cellules mémoire comprend une phase de précharge, par les amplificateurs de lecture, des lignes de bit auxquelles les cellules mémoire à lire sont reliées, et une phase de lecture proprement dite des cellules mémoire par les amplificateurs de lecture, la mémoire comprenant des moyens pour, pendant la phase de précharge, forcer le décodeur à relier chaque amplificateur de lecture à au moins deux lignes de bit d'une même colonne, puis, pendant la phase de lecture, libérer le décodeur pour que celui-ci relie chaque amplificateur de lecture à une ligne de bit et une seule de la colonne.

Selon un mode de réalisation, le décodeur de colonne comprend des blocs décodeurs pilotés par des signaux de prédécodage fournis par un étage prédécodeur recevant une adresse de colonne, chaque bloc décodeur reliant un amplificateur de lecture à un groupe de lignes de bit, et la mémoire comprend des moyens pour, en phase de précharge, forcer le prédécodeur à fournir des signaux de prédécodage de valeur déterminée, de manière que chaque bloc décodeur de colonne relie un amplificateur de lecture à au moins deux lignes de bit, puis, pendant la phase de lecture, libérer le prédécodeur de manière que chaque bloc décodeur relie un amplificateur de lecture à une ligne de bit et une seule.

Selon un mode de réalisation, la mémoire comprend une entrée série et reçoit une adresse de lecture bit à bit, et des moyens pour : sur réception d'une adresse partielle de lecture à laquelle il manque au moins un bit de plus faible poids pour former une adresse complète, précharger dans chaque groupe de lignes de bit des lignes de bit ayant la même adresse partielle, et sur réception de l'adresse complète, arrêter de précharger les lignes de bit qui ne sont pas désignées par l'adresse complète, puis lire les cellules mémoire désignées par l'adresse complète.

Selon un mode de réalisation, la mémoire est agencée pour continuer à précharger les lignes de bit désignées par une adresse complète sur réception de l'adresse complète, avant de déclencher la lecture proprement dite des cellules mémoire désignées par l'adresse complète.

Selon un mode de réalisation, la mémoire comprend des moyens pour : sur réception d'une première adresse partielle de lecture à laquelle il manque au moins deux bits de plus faible poids pour former une adresse complète, précharger dans chaque groupe de lignes de bit des lignes de bit ayant la même adresse partielle, et sur réception du bit d'adresse suivant formant avec la première adresse partielle une seconde adresse partielle, arrêter de précharger des lignes de bit qui ne sont pas désignées par la seconde adresse partielle.

Ces objets, caractéristiques et avantages ainsi que d'autres de la présente invention seront exposés plus en détail dans la description suivante du procédé de lecture selon l'invention et d'un exemple de réalisation d'une mémoire série mettant en oeuvre ce procédé, faite à titre non limitatif en relation avec les figures jointes parmi lesquelles :

- les figures 1A, 1B, 1C précédemment décrites illustrent une opération de lecture d'une mémoire série et représentent respectivement des données entrantes, un signal d'horloge entrant et des données sortantes,
- la figure 2 est le schéma électrique d'un amplificateur de lecture relié à des lignes de bit par un décodeur de colonne,
- la figure 3 représente sous forme de blocs la structure générale d'une mémoire série dans laquelle le procédé de l'invention est mis en oeuvre,
- la figure 4 représente la structure d'un bloc de décodage présent dans la mémoire de la figure 3,
- la figure 5 est le schéma logique d'une partie d'un prédécodeur de colonne présent dans la mémoire de la figure 3,
- les figures 6A à 6E illustrent la mise en oeuvre du procédé de l'invention dans la mémoire série de la figure 3 et représentent respectivement des signaux d'horloge, des signaux de données entrantes, un signal de précharge, un signal de sélection de ligne de bit et un signal de forçage de prédécodeur,
- la figure 7 est une courbe qui représente l'établissement d'une tension de lecture dans une ligne de bit selon un mode de réalisation du procédé de l'invention, et
- la figure 8 est une courbe qui représente l'établissement d'une tension de lecture dans une ligne de bit selon une variante de réalisation du procédé de l'invention.

La figure 2 représente un exemple classique de structure d'amplificateur de lecture SAi agencé dans une mémoire effaçable et programmable électriquement. L'amplificateur comprend un noeud de lecture SIN ("Sense In Node") et une sortie SOUT ("Sense Out"). Le noeud de lecture SIN est relié à la sortie d'un bloc de décodage BDi comprenant n entrées reliées à $n$ lignes de bit BLi, 0, BLi, 1...BL1, j....BLi, n formant un groupe de lignes de bit ou colonne d'un plan mémoire. Chaque ligne de bit est reliée' à une pluralité de cellules mémoire CELi,j,k (une seule étant représentée sur la figure). Chaque cellule mémoire CELi,j,k comprend un transistor à grille flottante FGT dont la grille est reliée à une ligne de mot WLk de rang k et dont le drain est directement relié à la ligne de bit BLi,j (cellule mémoire de type Flash).

L'amplificateur de lecture SAi comprend deux branches conductrices ST1, ST2 agencées en miroir de courant. La branche ST1 comprend un transistor PMOS TP1 et un transistor NMOS TN1 en série. La branche ST2 comprend un transistor PMOS TP2 et un transistor NMOS TN2 en série. Les transistors TP1, TP2 reçoivent sur leur source une tension Vcc et sur leur grille une tension de référence VREF. Le drain du transistor TP2 est relié au drain du transistor TN2, le drain du transistor TP1 est relié à la grille du transistor TN2 et au drain du transistor TN1 dont la source est reliée à la masse. La source du transistor TN2, formant le noeud de lecture SIN, est reliée à la grille du transistor TN1. Le noeud commun aux drains des transistors TP2, TN2 forme un noeud de sortie NOUT qui est appliqué à une porte inverseuse I1 dont la sortie forme la sortie SOUT de l'amplificateur de lecture. L'amplificateur de lecture comprend également un transistor de précharge PMOS TP3. La source de ce transistor reçoit la tension Vcc, son drain est relié au noeud NOUT et sa grille est pilotée par un signal PRECH. Le transistor de précharge présente généralement un rapport largeur sur longueur de grille (W/L) suffisamment élevé pour que le noeud SIN puisse porter rapidement la ligne de bit à une tension de lecture Vdread, en fournissant un courant de précharge Iprech suffisant pour contrer la présence de capacité parasites.

Dans l'art antérieur, la lecture d'une cellule mémoire, par exemple la cellule CELi,j,k représentée sur la figure 2, comprend les étapes suivantes :

- sélection de la ligne de bit BLi, k au moyen du bloc de décodage BDi, de manière que le noeud de lecture SIN de l'amplificateur SAi se trouve relié à cette ligne de bit,

- précharge de la ligne de bit par l'amplificateur SAi, en portant à 0 le signal PRECH de manière que le transistor TP3 soit passant, et
- lecture proprement dite de la cellule mémoire, en portant à 1 le signal PRECH et en appliquant une tension de lecture Vgread sur la grille de la cellule mémoire CELi,j,k, une donnée Di étant alors fournie par la sortie DOUT de l'amplificateur SAi.

Lorsque la phase de précharge est terminée, la tension Vdread appliquée à la ligne de bit, généralement de l'ordre de 1V, forme la tension drain-source du transistor à grille flottante FGT. Si la cellule mémoire est dans l'état effacé (tension de seuil du transistor FGT inférieure à Vgread) le transistor FGT est passant et le noeud NOUT est tiré vers 0, la sortie DOUT fournissant alors la donnée Di=1. Si la cellule mémoire est dans l'état programmé (tension de seuil du transistor FGT supérieure à Vgread), le transistor FGT est bloqué et le noeud NOUT reste à la tension Vcc (formant le "1" logique), la sortie DOUT fournissant alors la donnée Di=0.

Selon l'invention, l'amplificateur de lecture SAi est utilisé pour précharger au moins deux lignes de bit et la lecture d'une cellule mémoire comprend alors les étapes suivantes :

- deux lignes de bit, par exemple BLi, j et BLi, n sont sélectionnées au moyen du bloc de décodage BDi, de sorte que le noeud de lecture SIN de l'amplificateur SAi se trouve relié à ces deux lignes de bit,
- le signal PRECH est porté à 1 et les deux lignes de bit sont préchargées par l'amplificateur SAi (le rapport W/L du transistor de précharge TP3 étant choisi en conséquence),
- une ligne de bit parmi les deux sélectionnée, par exemple la ligne de bit BLi,n, est déconnectée du noeud de lecture SIN par le bloc de décodage BDi, et
- la cellule mémoire sur la ligne de bit restante, par exemple la cellule mémoire CELi,j,k est lue de façon conventionnelle en remettant à 1 le signal PRECH et en lisant la donnée Di fournie par la sortie de l'amplificateur de lecture.

Un tel procédé de lecture, comprenant la précharge de deux lignes de bit au lieu d'une avec le même amplificateur de lecture, s'applique avantageusement aux mémoires série et permet d'effectuer une précharge par anticipation de lignes de bit ayant la même adresse partielle.

Ceci sera mieux compris à la lecture de la description qui suit d'un exemple d'application du procédé de l'invention à une mémoire série.

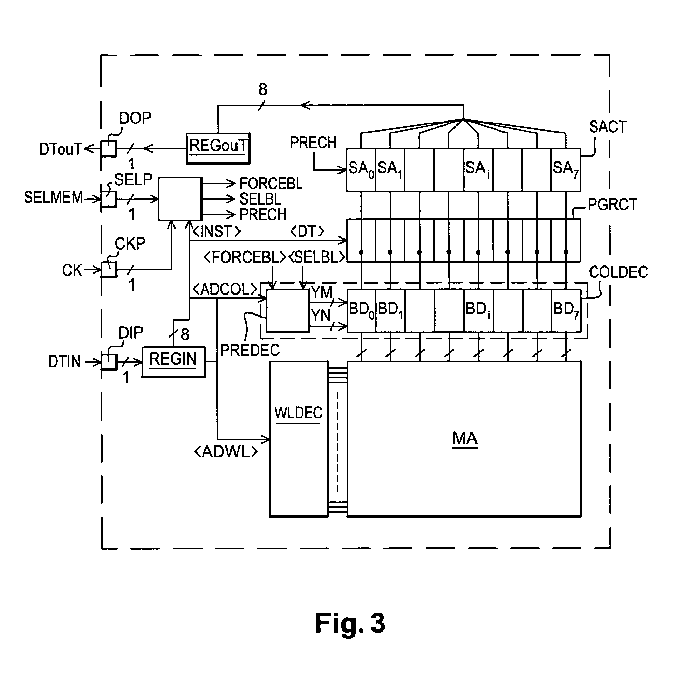

La figure 3 représente la structure classique d'une mémoire série SMEM, ici de type Flash, intégrée sur une microplaquette de silicium ("chip") présentant un contact DIP ("Data In Pad") formant une entrée série de la mémoire recevant des données DTIN, un contact DOP ("Data Out Pad") formant une sortie série de la mémoire émettant des données DOUT, un contact CKP formant une entrée de la mémoire recevant un signal d'horloge CK, et un contact SELP formant une entrée de la mémoire recevant un signal SELMEM de sélection de la mémoire. La mémoire SMEM comprend un plan mémoire MA, un décodeur de ligne de mot WLDEC, un décodeur de colonne COLDEC, un circuit de programmation PGRCT, un circuit de lecture SACT, un registre d'entrée REGIN de type série/parallèle, un registre de sortie REGOUT de type parallèle/série, et un séquenceur SEQ qui pilote ces divers éléments et exécute des instructions de lecture ou écriture. L'entrée série du registre REGIN est reliée au contact DTIN et sa sortie parallèle est reliée au séquenceur SEQ, au circuit PGRCT et aux décodeurs COLDEC, WLDEC, pour fournir respectivement à ces éléments des codes instruction INST, des adresses de ligne de mot ADWL, des adresses de colonne ADCOL, et des données DT à enregistrer dans le plan mémoire. Le circuit de lecture comprend ici huit amplificateurs de lecture SAi (SA0, SA1,... SA7) permettant de lire un mot de 8 bits ou octet dans le plan mémoire. Chaque amplificateur SAi est de même structure que celui décrit plus haut, et reçoit le signal PRECH qui est fournit ici par le séquenceur. Le décodeur COLDEC comprend 8 blocs de décodage BDi (BD0, BD1,... BD7), chaque bloc de décodage BDi reliant un amplificateur de lecture à un groupe de lignes de bit du plan mémoire MA, ou colonne. Les blocs de décodage BDi sont contrôlés ici par un prédécodeur de colonne PREDEC recevant l'adresse ADCOL et fournissant des signaux de prédécodage YM, YN. De façon classique, le prédécodeur PREDEC reçoit également un signal SELBL fourni par le séquenceur, qui active le prédécodage et provoque la fourniture des signaux YM, YN pour la sélection d'une ligne de bit par chacun des blocs de décodage BDi.

Selon l'invention, le séquenceur SEQ fournit également au prédécodeur, pendant la réception d'une adresse de lecture sur l'entrée DTIN, un signal FORCEBL qui provoque une modification des signaux de sélection YM, YN et force chacun des blocs de décodage BDi à sélectionner deux lignes de bit au lieu d'une. Comme cela sera décrit en détail plus loin, ce signal FORCEBL est activé (c'est-à-dire porté à une valeur active) lorsque le séquenceur a reçu une adresse de lecture partielle ne permettant pas encore de lire le mot désigné par l'adresse complète en cours de réception, mais permettant, selon l'invention, de commencer à précharger les lignes de bit ayant la même adresse partielle.

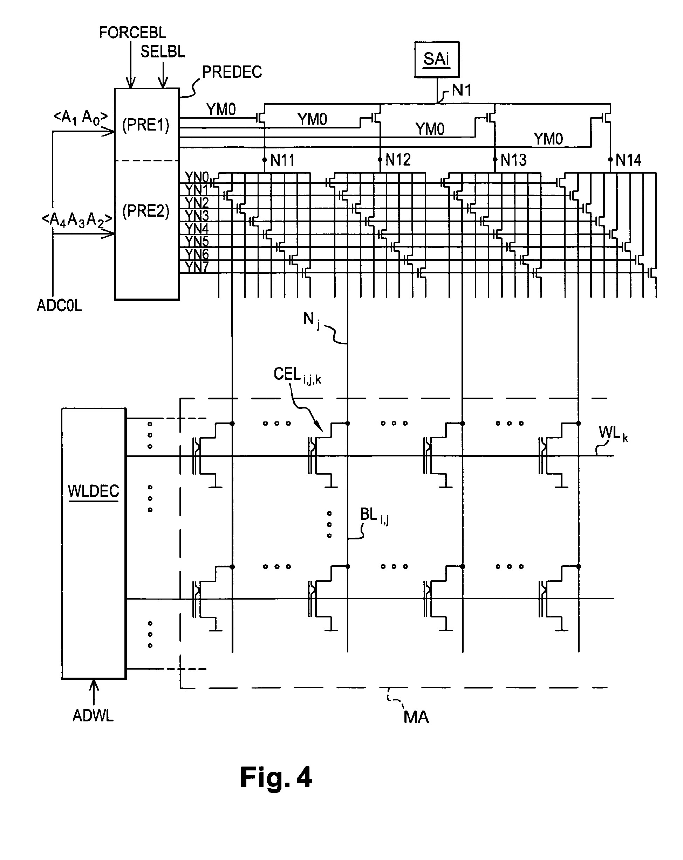

La figure 4 représente un exemple de réalisation d'un bloc de décodage BDi. On suppose ici que l'adresse de colonne appliquée au prédécodeur PREDEC comprend 5 bits d'adresse A4, A3, A2, A1, A0, ce qui correspond à une architecture de plan mémoire MA comprenant $2^5$ soit 32 lignes de bit par colonne de rang i. Le prédécodeur comprend un premier bloc de prédécodage PRE1 qui assure le prédécodage des bits d'adresse A1, A0 et fournit quatre signaux de prédécodage YM0, YM1, YM2, YM3, et un second bloc de prédécodage PRE2 qui assure le prédécodage des bits d'adresse A4, A3, A2 et fournit huit signaux de prédécodage YN7, YN6, YN5, YN4, YN3, YN2, YN1, YN0.

Le bloc de décodage BDi a la structure d'un multiplexeur et comprend n noeuds d'entrée Nj (j allant de 1 à *n*, *n* étant ici égal à 32) relié chacun à une ligne de bit BLi,j de même rang j. Les noeuds d'entrée sont agencés en quatre sous-groupes de huit noeuds d'entrée chacun. Tous les noeuds d'entrée d'un sous-groupe sont reliés à un noeud intermédiaire, respectivement N11, N12, N13, N14, par l'intermédiaire de transistors de sélection pilotés chacun par l'un des signaux YN7 à YN0. Chaque noeud N11 à N14 est relié à un noeud de sortie N1 par l'intermédiaire d'un transistor piloté par l'un des signaux YM0 à YM3. Le noeud de sortie N1 du bloc de décodage BDi est relié à l'amplificateur de lecture SAi de rang correspondant.

Cette structure de bloc de décodage BDi est en soi classique et est prévue dans l'art antérieur pour relier une ligne de bit et une seule à l'amplificateur de lecture SAi, pour la lecture d'une cellule mémoire reliée à la ligne de bit. Selon l'invention, la structure du bloc de prédécodage PRE1 est modifiée pour permettre la sélection simultanée de deux lignes de bit de même adresse partielle, afin de précharger simultanément ces lignes avec l'amplificateur SAi.

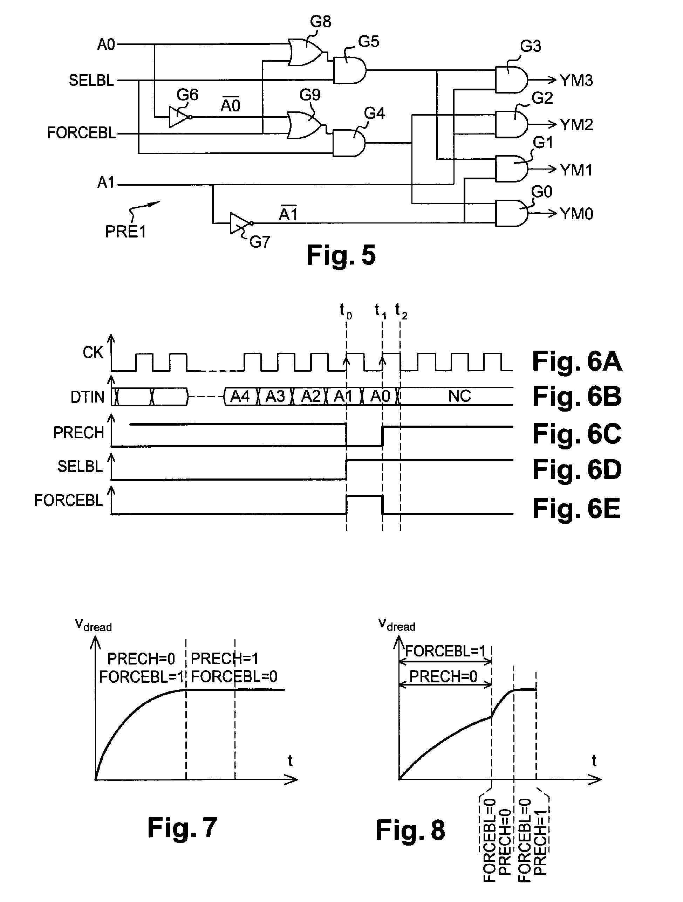

La figure 5 représente un exemple de réalisation du bloc de prédécodage PRE1 permettant de forcer la sélection de deux lignes de bit à la fois quand le signal FORCEBL est à 1. Celui-ci comprend six portes ET à deux entrées G0, G1, G2, G3, G4, G5, deux portes inverseuses G6, G7 et deux portes OU à deux entrées G8, G9. La porte G8 reçoit le bit d'adresse A0 et le signal FORCEBL. La porte G6 reçoit le bit d'adresse A0 et fournit un bit inversé /A0. La porte G7 reçoit le bit d'adresse A1 et fournit un bit inversé /A1. La porte G9 reçoit le bit /A0 et le signal FORCEBL. La porte G5 reçoit la sortie de la porte G8 et le signal SELBL. La porte G4 reçoit la sortie de la porte G9 et le signal SELBL. La porte G0 reçoit le bit inversé /A1 et la sortie de la porte G4 et fournit le signal YM0. La porte G1 reçoit le bit inversé /A1 et la sortie de la porte G5 et fournit le signal YM1. La porte G2 reçoit le bit A1 et la sortie de la porte G4 et fournit le signal YM2. La porte G3 reçoit le bit A1 et la sortie de la porte G5 et fournit le signal YM3. Ainsi, les signaux de prédécodage YM0, YM1, YM2, YM3 sont forcés à 0 quand le signal SELBL est à 0 et présentent les valeurs suivantes quand le signal SELBL est à 1 :

$$YM0 = /A1 * (/A0 + FORCEBL)$$

$$YM1 = /A1 * (A0 + FORCEBL)$$

$$YM2 = A1 * (/A0 + FORCEBL)$$

$$YM3 = A1 * (A0 + FORCEBL)$$

Il vient que les signaux de prédécodage présentent les valeurs suivantes quand le signal FORCEBL est à 0 :

$$YM0 = /A1 * /A0$$

$$YM1 = /A1 * A0$$

$$YM2 = A1 * /A0$$

$$YM3 = A1 * A0$$

et présentent les valeurs suivantes quand le signal FORCEBL est à 1 :

$$YM0 = /A1$$

$$YM1 = /A1$$

$$YM2 = A1$$

$$YM3 = A1$$

Ainsi, quand le signal FORCEBL est à 0, un seul des signaux de prédécodage YM0 à YM3 est à 1 pour une combinaison déterminée de valeurs des deux bits d'adresse de plus faible poids A1 et A0. Par contre, quand le signal FORCEBL est à 1, deux signaux de prédécodage YM0, YM1 ou YM2, YM3 sont simultanément à 1 pour une valeur déterminée de l'avant-dernier bit d'adresse A1, ce qui entraîne la sélection par le bloc de décodage BDi (figure 4) de deux lignes de bit ayant la même adresse partielle (soit ici deux lignes de bit ayant les même bits d'adresse de colonne A4, A3, A2, A1 et ne se distinguant que par des valeurs différentes du bit d'adresse de plus faible poids A0).

Les figures 6A à 6E sont des chronogrammes illustrant le contrôle d'une opération de lecture par le séquenceur SEQ. La figure 6A représente le signal d'horloge CK reçu sur l'entrée CKP (Cf. figure 3), la figure 6B représente les données DTIN reçues sur l'entrée DIP, la figure 6C représente le signal PRECH, la figure 6D représente le signal SELBL et la figure 6E représente le signal FORCEBL. On suppose que la mémoire a déjà reçu une instruction de lecture sous forme de données série ainsi que les bits d'adresse de poids fort formant l'adresse de la ligne de mot ADWL où se trouve le mot à lire, et qu'elle est en train de recevoir les bits d'adresse de poids faible A4, A3, A2, A1, A0 formant l'adresse de colonne du mot à lire.

A un instant t0 correspondant au front montant d'une impulsion du signal d'horloge, l'avant-dernier bit d'adresse A1 est reçu de sorte que l'adresse partielle du mot à lire, formée ici par l'adresse complète moins le dernier bit d'adresse A0, est connue. A cet instant, le séquenceur met à 1 le signal SELBL pour activer le décodeur de colonne et met à 0 le signal PRECH pour initier une phase de précharge. Simultanément, le signal FORCEBL est mis à 1 de sorte que, dans chaque colonne du plan mémoire, deux lignes de bit sont préchargées par l'amplificateur de lecture correspondant. Ces lignes de bit ont la même adresse partielle et leurs adresses complètes ne se distinguent que par des bits d'adresse A0 différents.

A un instant t1 correspondant au front montant suivant du signal d'horloge, le dernier bit d'adresse A0 est reçu et l'adresse complète du mot à lire est connue. A cet instant, le séquenceur remet à 0 le signal FORCEBL, de sorte qu'une ligne de bit et une seule désignée par l'adresse complète de colonne ADCOL se trouve sélectionnée dans chaque colonne du plan mémoire. Les autres lignes de bit, soit celles qui étaient également soumises à la phase de précharge, ne sont plus reliées aux amplificateurs de lecture. Simultanément, le signal PRECH est remis à 1 pour arrêter la phase de précharge. Un mot binaire est alors disponible à la sortie du circuit de lecture SACT (chaque amplificateur de lecture SAi fournissant un bit du mot) et est transféré par le séquenceur dans le registre de sortie REGOUT. A un instant correspondant ici au front descendant de la même impulsion du signal d'horloge, le premier bit de donnée est fourni par le registre REGOUT sur la sortie DOP (chronogramme non représenté, Cf. par analogie figure 1C).

La figure 7 représente la courbe de la tension de lecture Vdread pendant les phases de précharge et de lecture. Pendant la phase de précharge (FORCEBL=1, PRECH=0) la tension Vdread est appliquée à deux lignes de bit à la fois (dans chaque colonne) et est supposée stabilisée au commencement de la phase de lecture proprement dite (FORCEBL=0, PRECH=1) qui ne concerne plus qu'une seule ligne de bit par colonne.

Dans une variante de réalisation, la phase de précharge est maintenue après que l'adresse complète de la ligne de bit est connue, si la précharge de la ligne de bit n'est pas terminée. Dans ce cas, lorsque le signal FORCEBL est remis à 0 à l'instant t1, le signal PRECH est laissé à 0 pendant un laps de temps suffisant pour terminer la précharge de la ligne de bit restant sélectionnée. Cette variante est illustrée sur la figure 8, qui représente la courbe de la tension Vdread pendant les phases de précharge et de lecture. On distingue une première phase de précharge qui concerne deux lignes de bit (FORCEBL=1, PRECH=0), puis une phase de précharge complémentaire (FORCEBL=0, PRECH=0) qui ne concerne que la ligne de bit désignée par l'adresse complète reçue, puis la phase de lecture proprement dite (FORCEBL=0, PRECH=1). Pendant la phase de précharge complémentaire, tout le courant de précharge que peut fournir l'amplificateur de lecture est appliqué à la ligne de bit restant sélectionnée, et la tension Vdread présente une croissance plus rapide que pendant la première phase de précharge.

Il apparaîtra clairement à l'homme de l'art que la présente invention est susceptible de diverses variantes et perfectionnements. On a décrit dans ce qui précède un exemple de mise en oeuvre du procédé dans lequel chaque amplificateur de lecture assure la précharge de deux lignes de bit sur réception de l'avant-dernier bit d'adresse A1. Chaque amplificateur de lecture peut également assurer la précharge de quatre lignes de bit sur réception du bit d'adresse A2 (au lieu de A1), de huit lignes de bit sur réception du bit d'adresse A3, etc. s'il est souhaité d'anticiper plus avant le processus de précharge. Comme à chaque réception d'un nouveau bit d'adresse, une nouvelle adresse partielle plus complète que l'adresse partielle précédente est connue, il est préférable de déconnecter les lignes de bit qui ne sont plus concernées par la nouvelle adresse partielle afin de "soulager" les amplificateurs de lecture d'une charge capacitive trop importante et accélérer ainsi le processus de précharge et la croissance de la tension Vdread.

Les moyens de mise en oeuvre de la présente invention sont également susceptibles de diverses variantes. On a décrit ci-dessus un décodeur à prédécodage de structure classique dans lequel des portes G8, G9 sont ajoutées pour forcer les signaux de prédécodage à sélectionner deux lignes de bit. L'invention s'applique toutefois à tout type d'architecture de décodeur connue, avec ou sans étage de prédécodage.

Le procédé de l'invention, appliqué à une mémoire série, forme une sorte de procédé de précharge par anticipation plutôt qu'un procédé de lecture par anticipation. Toutefois, il peut être combiné avec un procédé classique de lecture par anticipation pour cumuler les avantages de chacun des procédés. Ainsi, peuvent par exemple être prévus 16 amplificateurs de lecture pour effectuer une lecture par anticipation comprenant les étapes suivantes :

- sur réception du bit A2, précharge de 32 lignes de bit au moyen des 16 amplificateurs de lecture, conformément au procédé de l'invention,
- sur réception du bit A1, lecture (comprenant éventuellement une phase de précharge complémentaire) de deux mots binaires de 8 bits chacun ayant la même adresse partielle, au moyen des 16 amplificateurs de lecture, et
- sur réception du bit A0, sélection du mot désigné par l'adresse complète parmi les deux mots lus par anticipation, et la fourniture du mot bit à bit sur la sortie série de la mémoire.

Dans cet exemple, le procédé de l'invention est mis en oeuvre sur réception du bit A2 et le procédé classique de lecture anticipée est mis en oeuvre sur réception du bit A1. Diverses autres variantes de réalisation du procédé de l'invention peuvent être prévues.

De façon générale, le procédé de l'invention est applicable à tout type de mémoire à accès série comprenant un plan mémoire comportant des lignes de bit nécessitant une phase de précharge, notamment les mémoires EEPROM, FLASH, ROM, etc.

## Revendications

1. Procédé de lecture de cellules mémoire (CELi,j,k) au moyen d'amplificateurs de lecture (SAi), les cellules mémoire étant reliées à des lignes de bit (BLi, j), la lecture de chaque cellule mémoire comprenant une phase de précharge de la ligne de bit à laquelle la cellule mémoire est reliée et une phase de lecture proprement dite de la cellule mémoire, procédé **caractérisé en ce que** chaque amplificateur de lecture (SAi) est utilisé pour précharger au moins deux lignes de bit, puis pour lire une cellule mémoire et une seule sur l'une des lignes de bit préchargées.

2. Procédé selon la revendication 1, dans lequel chaque amplificateur de lecture est relié à un groupe de lignes de bit (BLi,j) par l'intermédiaire d'un décodeur de colonne (COLDEC), et dans lequel le décodeur est utilisé pour relier chaque amplificateur de lecture à au moins deux lignes de bit pendant la phase de précharge, puis, pendant la phase de lecture, pour relier chaque amplificateur de lecture à une ligne de bit et une seule.

3. Procédé selon la revendication 2, dans lequel le décodeur de colonne (COLDEC) comprend des blocs décodeurs (BDi) pilotés par des signaux de prédécodage (YM, YN) fournis par un étage prédécodeur (PREDEC) recevant une adresse de colonne (ADCOL), chaque bloc décodeur reliant un amplificateur de lecture (SAi) à un groupe de lignes de bit, et comprenant une étape consistant à, pendant la précharge de lignes de bit, forcer (FORCEBL=1) le prédécodeur à fournir des signaux de prédécodage (YM0, YM1, YM2, YM3) de valeur déterminée, de manière que chaque bloc décodeur relie un amplificateur de lecture à au moins deux lignes de bit, puis, pendant la phase de lecture, libérer le prédécodeur (FORCEBL=0) de manière que chaque bloc décodeur de colonne relie un amplificateur de lecture à une ligne de bit et une seule.

4. Procédé selon l'une des revendications 1 à 3, appliqué à une mémoire série (SMEM) recevant bit à bit une adresse de lecture et comprenant les étapes suivantes :

   - sur réception d'une adresse partielle (A4-A1) de lecture à laquelle il manque au moins un bit de plus faible poids (A0) pour former une adresse complète, précharger des lignes de bit ayant la même adresse partielle en utilisant un seul et même amplificateur de lecture pour précharger au moins deux lignes de bit, et
   - sur réception de l'adresse complète (A4-A0), arrêter de précharger les lignes de bit qui ne sont pas désignées par l'adresse complète, et lire les cellules mémoire désignées par l'adresse complète.

5. Procédé selon la revendication 4 dans lequel les lignes de bit désignées par l'adresse complète continuent à être préchargées (fig. 8) après réception de l'adresse complète, avant d'engager la lecture proprement dite des cellules mémoire désignées par l'adresse complète.

6. Procédé selon l'une des revendications 3 à 5, comprenant les étapes suivantes :

   - sur réception d'une première adresse partielle de lecture à laquelle il manque au moins deux bits de plus faible poids pour former une adresse complète, précharger les lignes de bit ayant la même adresse partielle, et
   - sur réception du bit d'adresse suivant formant avec la première adresse partielle une seconde adresse partielle, arrêter de précharger des lignes de bit qui ne sont pas désignées par la seconde adresse partielle, afin de réduire la charge capacitive vue par les amplificateurs de lecture et accélérer la précharge des lignes de bit restant sélectionnées.

7. Mémoire (SMEM) comprenant des cellules mémoire (CELi,j,k) reliées à des lignes de bit (BLi,j), des amplificateurs de lecture (SAi) et un décodeur de colonne (COLDEC) reliant chaque amplificateur de lecture à un groupe de lignes de bit, dans laquelle la lecture de cellules mémoire comprend une phase de précharge, par les amplificateurs de lecture, des lignes de bit auxquelles les cellules mémoire à lire sont reliées, et une phase de lecture proprement dite des cellules mémoire par les amplificateurs de lecture, **caractérisée en ce qu'**elle comprend des moyens (SEQ, PREDEC, PRE1, G8, G9) pour, pendant la phase de précharge, forcer le décodeur à relier chaque amplificateur de lecture à au moins deux lignes de bit d'une même colonne, puis, pendant la phase de lecture, libérer le décodeur pour que celui-ci relie chaque amplificateur de lecture à une ligne de bit et une seule de la colonne.

**8.** Mémoire selon la revendication 7, dans laquelle le décodeur de colonne (COLDEC) comprend des blocs décodeurs (BDi) pilotés par des signaux de prédécodage (YM, YN) fournis par un étage prédécodeur (PREDEC, PRE1 PRE2) recevant une adresse de colonne (ADCOL), chaque bloc décodeur (BDi) reliant un amplificateur de lecture (SAi) à un groupe de lignes de bit, et comprenant des moyens (G8, G9) pour, en phase de précharge, forcer le prédécodeur à fournir des signaux de prédécodage (YM0, YM1, YM2, YM3) de valeur déterminée, de manière que chaque bloc décodeur de colonne relie un amplificateur de lecture à au moins deux lignes de bit, puis, pendant la phase de lecture, libérer le prédécodeur de manière que chaque bloc décodeur relie un amplificateur de lecture à une ligne de bit et une seule.

**9.** Mémoire selon l'une des revendications 7 et 8, comprenant une entrée série (DIP) et recevant une adresse de lecture bit à bit, et des moyens (SEQ) pour :

   - sur réception d'une adresse partielle de lecture (A4-AI) à laquelle il manque au moins un bit de plus faible poids (A0) pour former une adresse complète, précharger dans chaque groupe de lignes de bit des lignes de bit ayant la même adresse partielle, et
   - sur réception de l'adresse complète (A4-A0), arrêter de précharger les lignes de bit qui ne sont pas désignées par l'adresse complète, puis lire les cellules mémoire désignées par l'adresse complète.

**10.** Mémoire selon la revendication 9, agencée pour continuer à précharger (fig. 8) les lignes de bit désignées par une adresse complète sur réception de l'adresse complète (A4-A0), avant de déclencher la lecture proprement dite des cellules mémoire désignées par l'adresse complète.

**11.** Mémoire selon l'une des revendications 9 et 10, comprenant des moyens pour :

   - sur réception d'une première adresse partielle de lecture à laquelle il manque au moins deux bits de plus faible poids pour former une adresse complète, précharger dans chaque groupe de lignes de bit des lignes de bit ayant la même adresse partielle, et
   - sur réception du bit d'adresse suivant formant avec la première adresse partielle une seconde adresse partielle, arrêter de précharger des lignes de bit qui ne sont pas désignées par la seconde adresse partielle.

## Fig. 1A

CK

## Fig. 1B

DIN

(RINST) ──── (AD) ────

I₇ I₆ I₅ I₄ I₃ I₂ I₁ I₀ Aₙ Aₙ₁ ─── A4 A3 A2 A1 A0

## Fig. 1C

DouT

D7 D6 D5 D4 D3

t₁ t₂ Tᵣ

## Fig. 2

SAᵢ

Vcc    Vcc    Vcc

VREF ─ G│ TP1    G│ TP2    S│
         S          S  ST2 TP3│G ─ PRECH

         D   ST1    D          D
                      NouT          SouT ─ Dᵢ
                                    I₁

              D  G│ TN2
              ST1

         D    S
   TN1│        TN2

    S      SIN
   ▽

Iprech, Vdread

BDᵢ

BL i,∅    BL i,j    BL i,n
BL i,1

Iprech

CEL i,j,k        D│ FGT    D│ FGT
              G│         G│      WLₖ
Vgread                            CEL i,n,k
              S│          S│

10

**Fig. 3**

**Fig. 4**

**Fig. 5**

**Fig. 6A**

**Fig. 6B**

**Fig. 6C**

**Fig. 6D**

**Fig. 6E**

**Fig. 7**

**Fig. 8**

**Office européen des brevets**

## RAPPORT DE RECHERCHE EUROPEENNE

Numéro de la demande

EP 05 35 8010

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2003/109096 A1 (OTANI HIDENARI ET AL) 12 juin 2003 (2003-06-12) * alinéa [0081] - alinéa [0082]; figures 9,10 * ----- | 1-3,7,8 | G11C7/12 G11C7/10 |
| X | US 5 790 466 A (HOTTA ET AL) 4 août 1998 (1998-08-04) | 1 | |
| A | * colonne 1, ligne 20 - colonne 2, ligne 59; figures 1,2 * ----- | 5,7 | |
| D,A | EP 0 712 133 A (SGS-THOMSON MICROELECTRONICS S.A) 15 mai 1996 (1996-05-15) * colonne 6, ligne 3 - colonne 7, ligne 40; figures 1,2 * ----- | 1,7 | |

**DOMAINES TECHNIQUES RECHERCHES (IPC)**

G11C

Le présent rapport a été établi pour toutes les revendications

| Lieu de la recherche | Date d'achèvement de la recherche | Examinateur |
|---|---|---|
| Munich | 23 novembre 2005 | Harms, J |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 05 35 8010

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

23-11-2005

| Document brevet cité<br>au rapport de recherche | Date de<br>publication | Membre(s) de la<br>famille de brevet(s) | Date de<br>publication |
|---|---|---|---|
| US 2003109096  A1 | 12-06-2003 | US   2005128838 A1 | 16-06-2005 |
| US 5790466  A | 04-08-1998 | JP      3537010 B2<br>JP      9147580 A<br>KR       245244 B1 | 14-06-2004<br>06-06-1997<br>02-03-2000 |
| EP 0712133  A | 15-05-1996 | DE     69501203 D1<br>DE     69501203 T2<br>FR      2726934 A1<br>JP      3280214 B2<br>JP      8235851 A<br>US      5663922 A | 22-01-1998<br>02-04-1998<br>15-05-1996<br>30-04-2002<br>13-09-1996<br>02-09-1997 |

EPO FORM P0460

Pour tout renseignement concernant cette annexe : voir Journal Officiel de l'Office européen des brevets, No.12/82